# EUROPEAN PATENT SPECIFICATION

(11) **EP 4 124 640 B1**
(45) Date of publication and mention of the grant of the patent: **21.01.2026**
(21) Application number: 21187982.0
(22) Date of filing: 27.07.2021
(51) Int. Cl.: C09K 5/10, G06F 1/20, H05K 7/20

(54) **NOVEL USE FOR COOLANTS WITH LOW ELECTRICAL CONDUCTIVITY**
NEUARTIGE VERWENDUNG FÜR KÜHLMITTEL MIT NIEDRIGER ELEKTRISCHER LEITFÄHIGKEIT
NOUVELLE UTILISATION POUR DES RÉFRIGÉRANTS À FAIBLE CONDUCTIVITÉ ÉLECTRIQUE

(43) Date of publication of application: 01.02.2023
(73) Proprietor: BASF SE, 67056 Ludwigshafen am Rhein (DE)
(72) Inventor: HIROSUE, Masayuki, 67056 Ludwigshafen (DE); MALKOWSKY, Itamar Michael, 67056 Ludwigshafen (DE); NITZSCHE, Uwe, 67056 Ludwigshafen (DE); SCHINDLER, Nina, 67056 Ludwigshafen (DE); SCHULZ, Gerhard, 67056 Ludwigshafen (DE)
(74) Representative: BASF IP Association

(56) References cited:
- US-A1- 2006 219 975
- US-A1- 2014 239 222
- US-A1- 2019 352 553
- US-B2- 7 588 695

## Description

The present application describes the use of coolants with low electrical conductivity in direct or indirect cooling of electronic devices.

Heat removal is a common problem in modern server farms in order to prevent overheating of electronic devices, especially hard disks, memory, microprocessors or central processing units (CPU). When it is not possible to remove the warm air with the help of a fan, heat transfer fluids are used to remove the generated heat. The thus warmed up heat transfer fluid is then conveyed to a heat exchanger, cooled down, and circulated back in a loop.

As computational power increases within desktop computers, datacentres and telecommunications centres, so does the heat output.

Accordingly, devices such as personal computers operate with fans that air cool the heat produced by components such as microprocessors, memory, power supply, etc.

Telecommunication centres and datacentres, which are large networks of multiple electronic devices, make use of large distributed air conditioning systems that may constitute multiple fans, blowers, compressors and pumps that cool the air provided to the devices. Multiple heat transfer processes typically move the heat to outside air or groundwater. Power electronics devices often make use of large blowers applied to heat sinks attached to power electronics modules composed of semiconductor devices.

As the need for access to greater and greater processing and storage resources continues to expand, the density of server systems (i.e., the amount of processing power and/or storage placed on a single server, the number of servers placed in a single rack, and/or the number of servers and or racks deployed on a single server farm), continue to increase. With the desire for increasing processing or storage density in these server systems, the thermal challenges that result remain a significant obstacle. Conventional cooling systems (e.g., fan based) require large amounts of power, and the cost of power required to drive such systems increases exponentially with the increase in server densities. Consequently, there exists a need for efficient, low power usage system for cooling the servers, while allowing for the desired increased processing and/or storage densities of the server systems.

Use of liquid cooling is becoming increasingly popular for such devices. In many power electronic devices, the desired power density makes air cooling of the components within it impractical. In large data and telecommunications centres, liquid cooling is replacing air in many of the heat transfer processes in order to increase energy efficiency.

Cooling may take place directly (the heat-dissipating component is immersed directly in a heat transfer fluid) or indirectly (heat is transferred through a thermal interface material).

Usually organic, especially fluorinated organic liquids, see e.g. WO 2020/250104 A1 or WO 2018/224908 A1, are used as heat transfer fluids, since, water or water-based systems usually exhibit a certain electrical conductivity which may cause an electrical short circuit on direct contact with electrical components or, in the case of indirect cooling, in case of a leakage of the coolant loop.

On the other hand, organic heat transfer fluids often exhibit a low flashpoint and are flammable which leads to an inacceptable fire hazard. Fluorinated organic liquids are often non-flammable but are environmentally questionable due to their ozone-depleting potential or their atmospheric lifetime.

US 2014/0239222 A1 discloses aqueous cooling liquids comprising monopropylene glycol, triazole, and biocides for cooling of electronic components.

Although such coolants are disclosed not to cause corrosion to certain metals the anti-corrosion activity of the coolants is not yet sufficient.

US 2006/0219975 and US 2019/0352553 A1 disclose ready-to-use aqueous coolant compositions with a low electrical conductivity.

Such coolants are disclosed for use in fuel cells only, other applications are not disclosed.

WO 02/101848 and unpublished European Patent Application No. 20192954.4 filed on 26. August 2020 both disclose an aqueous coolant with low electrical conductivity for use in cooling systems of vehicles with electric engines, fuel cells or hybrid engines. Application of such coolants is limited to cooling fuel cells and electric vehicles but no further application is disclosed or render obvious.

It was an object of the present invention to provide an aqueous heat transfer fluid which may be used for electronic components even on direct contact.

The object was achieved by coolants, comprising
(A) at least one glycol
(B) water
(C) at least one azole derivative
(D) at least one ester of orthosilicic acid or alkoxy alkylsilane
(E) optionally at least one tertiary amine bearing at least one 2-hydroxyethyl- or 2-hydroxypropyl-group
(F) optionally at least one monocarboxylic acid
(G) optionally at least one silicophosphonate, and
(H) optionally at least one further coolant additive
wherein
- components (C) to (H) are present in amounts so that the coolant exhibits an electrical conductivity of less than 100, preferably less than 50, and more preferably less than 45 µS/cm.

In one preferred embodiment both components (E) and (F) are absent.

In another preferred embodiment both components (E) and (F) are present with the proviso that
- the molar ratio between tertiary amine (E) and monocarboxylic acid (F) is from 1 : 0.1 to 1 : 0.6, and
- components (C) to (H) are present in amounts so that the coolant exhibits an electrical conductivity of less than 100, preferably less than 50, and more preferably less than 45 µS/cm.

Such coolants exhibit both, a low electrical conductivity which makes them usable as coolants for heat-generating electronic devices, preferably electronic devices comprising a datacentre, more preferably electronic devices comprising a datacentre comprising an electronic component.

It is an advantage of the aqueous coolants according to the present invention that they are non-flammable and exhibit a higher heat capacity than the organic or fluorinated organic liquids known in the prior art which increases their effectiveness for cooling. Furthermore, the aqueous coolants according to the present invention exhibit a higher boiling point resp. enthalpy of evaporation than the organic or fluorinated organic liquids which lessens their vapour pressure at the operating temperature of the heat-dissipating component. Therefore, the coolant in the loop remains fluid without forming a second (gaseous) phase. Furthermore, the fluid is inert so that it is compatible with the materials of construction and the electrical components.

Another object of the present invention is the use of such aqueous coolants for thermally managing heat-generating electronic devices, preferably electronic devices comprising a datacentre, more preferably electronic devices comprising a datacentre comprising an electronic component.

Another object of the present invention is a method of thermally managing heat-generating electronic devices, preferably electronic devices comprising a datacentre, more preferably electronic devices comprising a datacentre comprising an electronic component by directly or indirectly bringing the heat-generating electronic devices in contact with the coolant, conveying the coolant to a heat exchanger and recirculating such aqueous coolants.

The methods may include at least partially immersing a heat generating component (e.g., a computer server) in the aqueous coolant. The method may further include transferring heat from the heat generating component using the aqueous coolant.

Another object of the present invention is a system comprising:
a heat-generating electronic device;
a thermal management system comprising at least one recirculating thermal management fluid,
the thermal management system designed so as to transfer heat from the heat-generating electronic device.

The system may be designed as an immersion cooling system which includes a housing having an interior space; a heat-generating component disposed within the interior space; and a working fluid liquid disposed within the interior space such that the heat-generating component is in contact with the working fluid liquid.

In some embodiments, a heat generating component may be disposed within the interior space such that it is at least partially immersed (and up to fully immersed) in the liquid phase of the working fluid.

In some embodiments, the heat generating components may include one or more electronic devices, such as computing servers.

In some embodiments, the present disclosure may be directed to an immersion cooling system which operates by single phase immersion cooling. Generally, the single phase immersion cooling system is similar to that of a two phase system in that it may include a heat generating component disposed within the interior space of a housing such that it is at least partially immersed (and up to fully immersed) in the liquid phase of the working fluid. The single phase system may further include a pump and a heat exchanger, the pump operating to move the working fluid to and from the heat generating components and the heat exchanger, and the heat exchanger operating to cool the working fluid. The heat exchanger may be disposed within or external to the housing.

"Heat-management fluid" and "heat-transfer fluid" and "heat-transfer medium" and "coolant" are used interchangeably herein and refer to fluids that can transfer heat from one location to another.

Details to the constituents are as follows:

### Glycol (A)

As alkylene glycol component or derivative thereof (A), it is possible to use, in particular, monoethylene glycol, diethylene glycol, triethylene glycol, tetraethylene glycol and mixtures thereof, but also monopropylene glycol, dipropylene glycol and mixtures thereof, 1,3-propanediol, higher poly alkylene glycols, alkylene glycol ethers, for example monoethylene glycol monomethyl ether, diethylene glycol monomethyl ether, triethylene glycol monomethyl ether, tetraethylene glycol monomethyl ether, monoethylene glycol monoethyl ether, diethylene glycol monoethyl ether, triethylene glycol monoethyl ether, tetraethylene glycol monoethyl ether, monoethylene glycol mono-n-butyl ether, diethylene glycol mono-n-butyl ether, triethylene glycol mono-n-butyl ether and tetraethylene glycol mono-n-butyl ether, or glycerol, in each case either alone or as mixtures thereof.

### Water (B)

Water used for the coolants according to the present invention should be ion-free, designating water with a neutral pH-value and comprising essentially no further ions than those hydroxide ions and hydronium ions out of the autoprotolysis of water at the respective temperature.

The electrical conductivity (throughout this text determined according to ASTM D 1125) at 25 °C of the ion-free water used should preferably not exceed 5 µS/cm, more preferably not more than 3, even more preferably not more than 2, and especially not more than 1 µS/cm.

The ion-free water used can be pure distilled or twice-distilled water or water which has been deionized, for example by ion exchange.

### Azole Derivatives (C)

Azole derivatives in the context of the present invention mean five-membered heterocyclic compounds having 2 or 3 heteroatoms from the group consisting of nitrogen and sulfur and comprise no or at most one sulfur atom and can bear an aromatic or saturated six-membered fusedon ring.

These five-membered heterocyclic compounds (azole derivatives) usually contain two N atoms and no S atom, 3 N atoms and no S atom or one N atom and one S atom as heteroatoms.

Preferred groups of the specified azole derivatives are annellated imidazoles and annellated 1,2,3-triazoles of the general formula 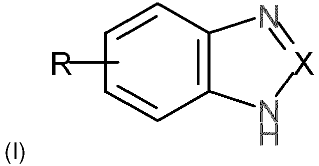 or 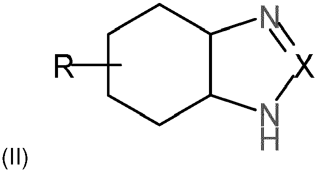 where
the variable R is hydrogen or a C₁-C₁₀-alkyl radical, in particular methyl or ethyl, and
the variable X is a nitrogen atom or the C-H group.

Typical and preferred examples of azole derivatives of the general formula (I) are benzimidazole (X = C-H, R = H), benzotriazoles (X = N, R = H) and tolutriazole (tolyltriazole) (X = N, R = CH₃). A typical example of an azole derivative of the general formula (II) is hydrogenated 1,2,3-tolutriazole (tolyltriazole) (X = N, R = CH₃).

A further preferred group of the specified azole derivatives is benzothiazoles of the general formula (III) 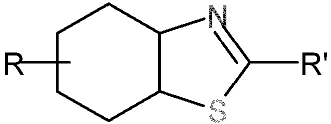 where
the variable R is as defined above and
the variable R' is hydrogen, a C₁-C₁₀-alkyl radical, in particular methyl or ethyl, or in particular a mercapto group (-SH). A typical example of an azole derivative of the general formula (III) is 2-mercaptobenzothiazole.

It is also possible, however less preferable, to use (2-benzothiazylthio)acetic acid (R' = -S-CH₂-COOH) or (2-benzothiazylthio) propionic acid (R' = -S-CH₂-CH₂-COOH). This embodiment is less preferable since the use of such free-acid compounds would increase the electrical conductivity of the coolant.

Further suitable azole derivatives are non-annellated azole derivatives of the general formula (IV) 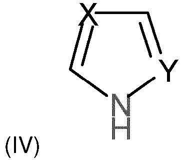 where
the variables X and Y together are two nitrogen atoms or
one nitrogen atom and a C-H group,
for example 1H-1,2,4-triazole (X = Y = N) or preferably imidazole (X = N, Y = C-H).

For the purposes of the present invention, benzimidazole, benzotriazole, tolutriazole, hydrogenated tolutriazole or mixtures thereof, in particular benzotriazole or tolutriazole, are very particularly preferred as azole derivatives.

The azole derivatives mentioned are commercially available or can be prepared by conventional methods. Hydrogenated benzotriazoles such as hydrogenated tolutriazole are likewise obtainable as described in DE-A 1 948 794 and are also commercially available.

### Esters of Orthosilicic Acid or Alkoxy Alkylsilanes (D)

Esters of orthosilicic acid are compounds of the formula

Si(OR¹)₄

wherein
R¹ is an organic substituent comprising 1 to 6 carbon atoms, for example a linear or branched, preferably a linear alkyl substituent comprising 1 to 6 carbon atoms or an aromatic substituent comprising 6 carbon atoms, more preferably an alkyl substituent comprising 1 to 4 carbon atoms and even more preferably an alkyl substituent comprising 1 or 2 carbon atoms.

Alkoxy alkylsilanes are less preferred and both the alkoxy substituent as well as the alkyl group comprise a linear or branched, preferably a linear alkyl substituent comprising 1 to 6 carbon atoms, more preferably an alkyl substituent comprising 1 to 4 carbon atoms and even more preferably an alkyl substituent comprising 1 or 2 carbon atoms.

Typical examples of compounds (D) are tetraalkoxysilanes, preferably tetramethoxysilane and tetraethoxysilane, and alkoxyalkylsilanes, preferably triethoxymethylsilane, diethoxydime-thylsilane, ethoxytrimethylsilane, trimethoxymethylsilane, dimethoxydimethylsilane and methoxytrimethylsilane. Preference is given to tetraalkoxysilanes, particularly preferably tetramethoxysilane and tetraethoxysilane, with very particular preference being given to tetraethoxysilane.

Compounds (D) are mainly used as inhibitors of aluminium corrosion.

### Tertiary Amine (E) (optional)

The at least one tertiary amine (E) bears at least one 2-hydroxyethyl- or 2-hydroxypropyl-group. Potential tertiary amines (E) may bear one, two or three 2-hydroxyethyl- or 2-hydroxypropyl-groups, preferably two or three 2-hydroxyethyl- or 2-hydroxypropyl-groups and more preferably 2-hydroxyethyl-groups.

The substituents of the tertiary amine (E) not being a 2-hydroxyethyl- or 2-hydroxypropyl-group may be aliphatic, cycloaliphatic or aromatic groups with up to 20 carbon atoms, preferably with up to 18, more preferably with up to 16, even more preferably with up to 14, and especially up to 12 carbon atoms.

These substituents are preferably aliphatic or aromatic and more preferably aliphatic.

### Aromatic substituents can be e.g. phenyl, tolyl or naphthyl.

Aliphatic substituents may be linear or branched, preferred are linear alkyl substituents comprising 1 to 18 carbon atoms, preferably 2 to 16, more preferably 4 to 14, and especially 6 to 12 carbon atoms.

In the compounds (E) the substituent is preferably derived from fatty amines which are preferably obtainable by hydrogenation and amination of fatty acids and esters, particularly preferably by hydrogenation and amination of 2-ethylhexanoic acid, octanoic acid (caprylic acid), pelargonic acid (nonanoic acid), 2-propylheptanoic acid, decanoic acid (capric acid), undecanoic acid, dodecanoic acid (lauric acid), tridecanoic acid, tetradecanoic acid (myristic acid), pentadecanoic acid, palmitic acid (hexadecanoic acid), palmitoleic acid [(9Z)-hexadec-9-enoic acid], margaric acid (heptadecanoic acid), stearic acid (octadecanoic acid), oleic acid [(9Z)-octadec-9-enoic acid], elaidic acid [(9E)-octadec-9-enoic acid], linoleic acid [(9Z,12Z)-octadeca-9,12-dienoic acid], linolenic acid [(9Z, 12Z, 15Z)-octadeca-9, 12, 15-trienoic acid], eleostearic acid [(9Z,11E,13E)-octadeca-9,11,13-trienoic acid], ricinoleic acid ((R)-12-hydroxy-(Z)-octadec-9-enoic acid), isoricinoleic acid [(S)-9-hydroxy-(Z)-octadec-12-enoic acid], nonadecanoic acid, arachidic acid (eicosanoic acid), behenic acid (docosanoic acid) and erucic acid [(13Z)-docos-13-enoic acid].

Examples for tertiary amines (E) bearing one 2-hydroxyethyl- or 2-hydroxypropyl-group and two other substituents are those of the general formula (I) 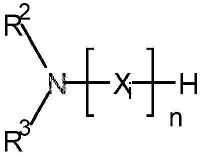 where
R² and R³ independently of another each are a substituent as described above, preferably a linear or branched, preferred a linear alkyl substituent comprising 1 to 18 carbon atoms, preferably 2 to 16, more preferably 4 to 14, and especially 6 to 12 carbon atoms, or together may form a five- or six-membered ring including the nitrogen atom,
Xᵢ is -CH₂-CH₂-O-, -CH₂-CH(CH₃)-O- or -CH(CH₃)-CH₂-O-, preferably -CH₂-CH₂-O-, and
n is a positive integer from 1 to 5, preferably from 1 to 4, more preferably from 1 to 3, even more preferably 1 or 2, and especially 1.

Preferred individuals are dimethyl ethanolamine, dimethyl propanolamine, diethyl ethanolamine, diethyl propanolamine, di-n-butyl ethanolamine, di-n-butyl propanolamine, N-hydroxyethyl pyrrolidine, N-hydroxyethyl piperidine, and N-hydroxyethyl morpholine.

Examples for tertiary amines (E) bearing two 2-hydroxyethyl- or 2-hydroxypropyl-groups and one other substituent are of the general formula (II) 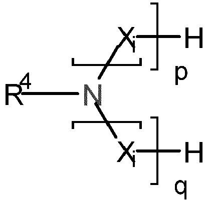 where
R⁴ is a substituent as described above, preferably a linear or branched, preferred a linear alkyl substituent comprising 1 to 18 carbon atoms, preferably 2 to 16, more preferably 4 to 14, and especially 6 to 12 carbon atoms,
each Xi for i = 1 to p and 1 to q is independently selected from the group consisting of -CH₂-CH₂-O-, -CH₂-CH(CH₃)-O- or -CH(CH₃)-CH₂-O-, preferably -CH₂-CH₂-O-, and
p and q independently of another are a positive integer from 1 to 5, preferably from 1 to 4, more preferably from 1 to 3, even more preferably 1 or 2, and especially 1.

Preferred individuals are the bis(2-hydroxyethyl) amines or bis(2-hydroxypropyl) amines bearing as substituent R⁴ n-hexylamine, 2-methylpentylamine, n-heptylamine, 2-heptylamine, isoheptylamine, 1-methylhexylamine, n-octylamine, 2-ethylhexylamine, 2-aminooctane, 6-methyl-2-heptylamine, n-nonylamine, isononylamine, n-decylamine and 2-propylheptylamine or mixtures thereof.

Particular preference is given to bis(2-hydroxyethyl)-substituted n-hexylamine, n-octylamine, 2-ethylhexylamine and n-decylamine, with n-octylamine and 2-ethylhexylamine, in particular bis(2-hydroxyethyl) n-octylamine, being particularly preferred.

These compounds are preferably obtainable by reacting the corresponding amines R⁴-NH₂ with alkylene oxides to the desired average statistical degree of alkoxylation, preferably under basic conditions. This is particularly preferred when the structural unit Xᵢ is derived from ethylene oxide or propylene oxide, preferably from ethylene oxide.

Examples for tertiary amines (E) bearing three 2-hydroxyethyl- or 2-hydroxypropyl-groups are triethanolamine and tripropanolamine, preferably triethanolamine.

Preferred amines (E) are dimethyl ethanolamine, dimethyl propanolamine, diethyl ethanolamine, di-n-butyl ethanolamine, N-hydroxyethyl morpholine, bis(2-hydroxyethyl) n-hexylamine, bis(2-hydroxyethyl) n-octylamine, bis(2-hydroxyethyl) 2-ethylhexylamine, bis(2-hydroxyethyl) n-decylamine, and triethanolamine.

### Monocarboxylic Acid (F) (optional)

Suitable monocarboxylic acids (F) may be linear or branched-chain, aliphatic, cycloaliphatic or aromatic monocarboxylic acids with up to 20 carbon atoms, preferably with from 2 to 18, more preferably with from 5 to 16, even more preferably with from 5 to 14, most preferably with from 6 to 12, and especially with from 8 to 10 carbon atoms.

Branched-chain aliphatic monocarboxylic acids are preferred of the corresponding linear monocarboxylic acids.

Useful linear or branched-chain, aliphatic or cycloaliphatic monocarboxylic acids (F) are, for example, propionic acid, pentanoic acid, 2,2-dimethylpropanoic acid, hexanoic acid, 2,2-dimethylbutaneoic acid, cyclohexyl acetic acid, octanoic acid, 2-ethylhexanoic acid, nonanoic acid, isononanoic acid, decanoic acid, undecanoic acid or dodecanoic acid.

A suitable aromatic monocarboxylic acid (F) is in particular benzoic acid; additionally useful are also, for example, C₁- to C₈-alkylbenzoic acids such as o-, m-, p-methylbenzoic acid or p-tert-butylbenzoic acid, and hydroxyl-containing aromatic monocarboxylic acids such as o-, m- or p-hydroxybenzoic acid, o-, m- or p-(hydroxymethyl)benzoic acid or halobenzoic acids such as o-, m- or p-fluorobenzoic acid.

Especially preferred are 2-ethylhexanoic acid and isononanoic acid.

As used herein, isononanoic acid refers to one or more branched-chain aliphatic carboxylic acids with 9 carbon atoms. Embodiments of isononanoic acid used in the engine coolant composition may include 7-methyloctanoic acid (e.g., CAS Nos. 693-19-6 and 26896-18-4), 6,6-dimethylheptanoic acid (e.g., CAS No. 15898-92-7), 3,5,5-trimethylhexanoic acid (e.g., CAS No. 3302-10-1), 3,4,5-trimethylhexanoic acid, 2,5,5-trimethylhexanoic acid, 2,2,4,4-tetramethylpentanoic acid (e.g., CAS No. 3302-12-3) and combinations thereof. In a preferred embodiment, isononanoic acid has as its main component greater than 90% of one of 7-methyloctanoic acid, 6,6-dimethylheptanoic acid, 3,5,5-trimethylhexanoic acid, 3,4,5-trimethylhexanoic acid, 2,5,5-trimethylhexanoic acid, and 2,2,4,4-tetramethylpentanoic acid. The balance of the isononanoic acid may include other nine carbon carboxylic acid isomers and minor amounts of one or more contaminants. In a preferred embodiment, the isononanoic acid has as its main component greater than 90% of 3,5,5-trimethylhexanoic acid and even more preferably, the main component is greater than 95% 3,5,5-trimethylhexanoic acid.

It is possible, however disadvantageous, to use carboxylic acids with a higher functionality, e.g. di- or tricarboxylic acids, in addition to or instead of the monocarboxylic acids. The use of monocarboxylic acids has been shown to yield superior results compared to commonly used dicarboxylic acids, see examples.

If used, di- or tricarboxylic acids can be aliphatic, cycloaliphatic or aromatic, preferably aliphatic or aromatic and more preferably aliphatic with up to 20 carbon atoms, preferably with up to 18, more preferably with up to 16, even more preferably with up to 14, and especially up to 12 carbon atoms.

If used, examples of dicarboxylic acids are oxalic acid, malonic acid, succinic acid, glutaric acid, adipic acid, pimelic acid, suberic acid, azelaic acid, sebacic acid, undecanedioic acid, dodecanedioic acid, alkyl or alkenyl succinic acids, 2-metylbutane dioic acid, 2-ethylpentanedioic acid, 2-n-dodecylbutanedioic acid, 2-ndodecenylbutanedioic acid, 2-phenylbutanedioic acid, 2-(p-methylphenyl) butanedioic acid, 2,2-dimethylbutanedioic acid, 2,3-dimethylbutanedioic acid; 2,3,4 trimethylpentanedioic acid, 2,2,3-trimethylpentanedioic acid; 2-ethyl-3-methylbutanedioic maleic acid, fumaric acid, pent-2-enedioic acid, hex-2-enedioic acid; hex-3-endioic acid; 5-methylhex-2-enedioic acid; 2,3-dimethylpent-2-enedioic acid; 2-methylbut-2-enedioic acid, 2-dodecylbut-2-enedioic acid, phthalic acid, isophthalic acid, terephthalic acid and substituted phthalic acids such as 3-methylbenzene-1,2-dicarboxylic acid; 4-phenylbenzene-1,3-dicarboxylic acid; 2-(1-propenyl) benzene-1,4-dicarboxylic acid, and 3,4-dimethylbenzene-1,2-dicarboxylic acid.

If used, examples of tricarboxylic acids are benzene tricarboxylic acids (all isomers) and triazinetriiminocarboxylic acids such as 6,6',6"-(1,3,5-triazine-2,4,6-triyltriimino)trihexanoic acid.

In a preferred embodiment the coolants according to the invention do not contain any carboxylic acids with a functionality higher than 1.

### Silicophosphonate (G)

As an optional constituent it is possible to use at least one silicophosphonate (G) in the coolant according to the invention.

Silicophosphonates are those of the general structure (V) 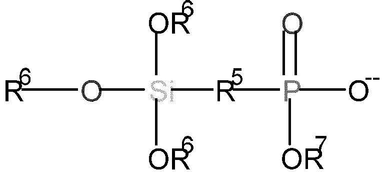 where
R⁵ is a bivalent organic residue, preferably a 1,ω-alkylene group with 1 to 6, preferably 1 to 4 carbon atoms, more preferably methylene, 1,2-ethylene, 1,2-propylene, 1,3-propylene or 1,4-butylene, most preferably 1,2-ethylene or 1,3-propylene, and especially 1,2-ethylene,
R⁶ and R⁷are independently of another C₁- to C₄-alkyl, preferably methyl, ethyl, n-propyl, isopropyl, n-butyl, iso-butyl, sec-butyl or tert-butyl, preferably methyl or ethyl.

Such silicophosphonates may exist as free phosphonate acid or in the form of their sodium or potassium salts, preferably sodium or potassium salt, more preferably as sodium salt.

### Further Coolant Additives (H)

It is further possible to add further typical coolant additives to the coolants of the present invention, as long as they do not increase the electrical conductivity above the critical value pointed out above.

Such typical coolant additives may be corrosion inhibitors against corrosion of tin, silver, and solder.

As further customary assistants, the inventive coolant may also comprise, in customary small amounts, defoamers (generally in amounts of from 0.003 to 0.008% by weight) and, for reasons of hygiene and safety in the event that it is swallowed, bitter substances (for example of the denatonium benzoate type) and dyes.

Wherever possible the use of non-ionic additives is preferred over ionic alternatives as long as a similar effect can be achieved using the non-ionic additives.

### Composition

Main requirement of the coolants according to the present invention is that the coolants should exhibit an electrical conductivity at 25 °C of less than 50, preferably less than 45 µS/cm (determined according to ASTM D 1125) to make the suitable for cooling systems of vehicles with electric engines.

In order to achieve that purpose the amount of ionic species, species which may contain ionic byproducts or combination of species which may form ions, such as acids and bases, should be kept at a minimum in order not to raise the electrical conductivity over the critical value.

Therefore, the amount of components (C) to (H) in the coolant are chosen in a way that the critical value for the electrical conductivity is not exceeded.

Typically, the coolants according to the invention are composed as follows:
(A) at least one glycol: 10 to 90 wt%, preferably 20 to 80 wt%, more preferably 30 to 70 wt%
(B) water: 10 to 90 wt%, preferably 20 to 80 wt%, more preferably 30 to 70 wt%
(C) at least one azole derivative: 0.01 to 1 wt%, preferably 0.02 to 0.9 wt%, more preferably 0.03 to 0.8 wt%, even more preferably 0.04 to 0.5, especially 0.05 to 0.3 wt%
(D) at least one ester of orthosilicic acid or alkoxy alkylsilane: 0.01 to 1 wt%, preferably 0.02 to 0.9 wt%, more preferably 0.03 to 0.8 wt%, even more preferably 0.04 to 0.5, especially 0.05 to 0.3 wt%
(G) optionally at least one silicophosphonate: 0 to 1 wt%, preferably 0.01 to 0.8 wt%, more preferably 0.02 to 0.6 wt%
(H) optionally at least on further coolant additive: 0 to 0.5 wt% for each further coolant additive, preferably 0.01 to 0.4 wt%, more preferably 0.02 to 0.3 wt%.
with the proviso that the sum of all components always add up to 100 wt%,
wherein
no tertiary amines (E) and no monocarboxylic acid (F) are present.

In another embodiment tertiary amines (E) and/or monocarboxylic acid (F), preferably both (E) and (F) are present in amounts as specified below.

In order to keep combinations of ion-forming species at a minimum the molar ratio between tertiary amine (E) and monocarboxylic acid (F) is from 1 : 0.1 to 1 : 0.6, preferably from 0.15 to 0.5 and more preferably from 0.2 to 0.4.

Reference is the number amount of amino- respectively carboxylic acid groups in compounds (E) respectively (F) in case molecules are used with a functionality higher than 1.

Typically, the coolants according to the invention are composed as follows:
(A) at least one glycol: 10 to 90 wt%, preferably 20 to 80 wt%, more preferably 30 to 70 wt%
(B) water: 10 to 90 wt%, preferably 20 to 80 wt%, more preferably 30 to 70 wt%
(C) at least one azole derivative: 0.01 to 1 wt%, preferably 0.02 to 0.9 wt%, more preferably 0.03 to 0.8 wt%, even more preferably 0.04 to 0.5, especially 0.05 to 0.3 wt%
(D) at least one ester of orthosilicic acid or alkoxy alkylsilane: 0.01 to 1 wt%, preferably 0.02 to 0.9 wt%, more preferably 0.03 to 0.8 wt%, even more preferably 0.04 to 0.5, especially 0.05 to 0.3 wt%
(E) at least one tertiary amine bearing at least one 2-hydroxyethyl- or 2-hydroxypropyl-group: 0.01 to 1 wt%, preferably 0.015 to 0.9 wt%, more preferably 0.02 to 0.8 wt%
(F) at least one monocarboxylic acid: 0.01 to 1 wt%, preferably 0.015 to 0.8 wt%, more preferably 0.02 to 0.6 wt%
(G) optionally at least one silicophosphonate: 0 to 1 wt%, preferably 0.01 to 0.8 wt%, more preferably 0.02 to 0.6 wt%
(H) optionally at least on further coolant additive: 0 to 0.5 wt% for each further coolant additive, preferably 0.01 to 0.4 wt%, more preferably 0.02 to 0.3 wt%.
with the proviso that the sum of all components always add up to 100 wt%.

A further embodiment of the present invention are coolant concentrates. Coolants usually are obtained from coolant concentrates by dilution with water (B). Hence, the coolant concentrates usually contain little or no water (B).

Typically, in one embodiment the coolant concentrates according to the invention are composed as follows:
(A) at least one glycol: 50 to 99,9 wt%, preferably 60 to 99,8 wt%, more preferably 75 to 99,7 wt%
(B) water: 0 to 10 wt%, preferably 0 to 8 wt%, more preferably 0 to 5 wt%
(C) at least one azole derivative: 0.02 to 1 wt%, preferably 0.04 to 0.8 wt%, more preferably 0.06 to 0.6 wt%, even more preferably 0.08 to 0.5, especially 0.1 to 0.4 wt%
(D) at least one ester of orthosilicic acid or alkoxy alkylsilane: 0.02 to 1 wt%, preferably 0.04 to 0.8 wt%, more preferably 0.06 to 0.6 wt%, even more preferably 0.08 to 0.5, especially 0.1 to 0.4 wt%
(E) at least one tertiary amine bearing at least one 2-hydroxyethyl- or 2-hydroxypropyl-group: 0.02 to 0.8 wt%, preferably 0.03 to 0.6 wt%, more preferably 0.04 to 0.5 wt%
(F) at least one monocarboxylic acid: 0.01 to 0.5 wt%, preferably 0.02 to 0.3 wt%, more preferably 0.03 to 0.2 wt%
(G) optionally at least one silicophosphonate: 0 to 1 wt%, preferably 0.02 to 0.8 wt%, more preferably 0.04 to 0.6 wt%
(H) optionally at least on further coolant additive: 0 to 0.5 wt% for each further coolant additive, preferably 0.002 to 0.4 wt%, more preferably 0.004 to 0.3 wt%.
with the proviso that the sum of all components always add up to 100 wt%.

In another embodiment the coolant concentrates according to the invention lacks components (E) and (F) and are composed as follows:
(A) at least one glycol: 50 to 99,9 wt%, preferably 60 to 99,8 wt%, more preferably 75 to 99,7 wt%
(B) water: 0 to 10 wt%, preferably 0 to 8 wt%, more preferably 0 to 5 wt%
(C) at least one azole derivative: 0.02 to 1 wt%, preferably 0.04 to 0.8 wt%, more preferably 0.06 to 0.6 wt%, even more preferably 0.08 to 0.5, especially 0.1 to 0.4 wt%
(D) at least one ester of orthosilicic acid or alkoxy alkylsilane: 0.02 to 1 wt%, preferably 0.04 to 0.8 wt%, more preferably 0.06 to 0.6 wt%, even more preferably 0.08 to 0.5, especially 0.1 to 0.4 wt%
(G) optionally at least one silicophosphonate: 0 to 1 wt%, preferably 0.02 to 0.8 wt%, more preferably 0.04 to 0.6 wt%
(H) optionally at least on further coolant additive: 0 to 0.5 wt% for each further coolant additive, preferably 0.002 to 0.4 wt%, more preferably 0.004 to 0.3 wt%.
with the proviso that the sum of all components always add up to 100 wt%.

A further embodiment of the present invention are coolant super concentrates. Coolant concentrates usually are obtained from coolant super concentrates by dilution with the glycol (A), respectively coolants may be obtained from coolant super concentrates by dilution with the glycol (A) and water (B). Hence, the coolant concentrates usually contain little or no water (B) and little or no glycol (A).

Typically, in one embodiment the coolant super concentrates according to the invention are composed as follows:
(A) at least one glycol: 70 to 99,5 wt%, preferably 80 to 99 wt%, more preferably 90 to 98 wt%
(B) water: 0 to 10 wt%, preferably 0 to 8 wt%, more preferably 0 to 5 wt%
(C) at least one azole derivative: 0.05 to 5 wt%, preferably 0.1 to 4 wt%, more preferably 0.2 to 3 wt%, even more preferably 0.3 to 2, especially 0.4 to 1.5 wt%
(D) at least one ester of orthosilicic acid or alkoxy alkylsilane: 0.05 to 5 wt%, preferably 0.1 to 4 wt%, more preferably 0.2 to 3 wt%, even more preferably 0.3 to 2, especially 0.4 to 1.5 wt%
(E) at least one tertiary amine bearing at least one 2-hydroxyethyl- or 2-hydroxypropyl-group: 0.1 to 4 wt%, preferably 0.15 to 3 wt%, more preferably 0.2 to 2.5 wt%
(F) at least one monocarboxylic acid: 0.05 to 1 wt%, preferably 0.1 to 0.9 wt%, more preferably 0.2 to 0.8 wt%
(G) optionally at least one silicophosphonate: 0 to 5 wt%, preferably 0.02 to 4 wt%, more preferably 0.04 to 3 wt%
(H) optionally at least on further coolant additive: 0 to 1 wt% for each further coolant additive, preferably 0.005 to 0.8 wt%, more preferably 0.008 to 0.6 wt%.
with the proviso that the sum of all components always add up to 100 wt%.

In another embodiment the coolant super concentrates according to the invention lacks componente (E) and (F) and are composed as follows:
(A) at least one glycol: 70 to 99,5 wt%, preferably 80 to 99 wt%, more preferably 90 to 98 wt%
(B) water: 0 to 10 wt%, preferably 0 to 8 wt%, more preferably 0 to 5 wt%
(C) at least one azole derivative: 0.05 to 5 wt%, preferably 0.1 to 4 wt%, more preferably 0.2 to 3 wt%, even more preferably 0.3 to 2, especially 0.4 to 1.5 wt%
(D) at least one ester of orthosilicic acid or alkoxy alkylsilane: 0.05 to 5 wt%, preferably 0.1 to 4 wt%, more preferably 0.2 to 3 wt%, even more preferably 0.3 to 2, especially 0.4 to 1.5 wt%
(G) optionally at least one silicophosphonate: 0 to 5 wt%, preferably 0.02 to 4 wt%, more preferably 0.04 to 3 wt%
(H) optionally at least on further coolant additive: 0 to 1 wt% for each further coolant additive, preferably 0.005 to 0.8 wt%, more preferably 0.008 to 0.6 wt%.
with the proviso that the sum of all components always add up to 100 wt%.

Because of their low electrical conductivity the coolants according to the present invention may be used in cooling systems of cooling of electronic devices.

### System

The heat-generating electronic devices can be any electronic device or system that includes an electronic element that typically generates heat. Exemplary heat-generating electronic elements include semiconductor integrated circuits (ICs), power transistors, resistors, and electroluminescent elements. The electronic devices can include, but are not limited to microprocessors, wafers used to manufacture semiconductor devices, power control semiconductors, circuit boards, multi-chip modules, packaged or unpackaged semiconductor devices, semiconductor integrated circuits. Other devices include personal computers, microprocessors, servers, cell phones, and personal digital assistants. Datacentres, which are a collection of computer systems and associated components, such as telecommunications and storage systems that generally include redundant or backup power, redundant data communications connections, environmental controls (including, for example, air conditioning and fire suppression), and security devices, are also within the scope of the provided protection systems.

Such heat-generating electronic devices may be mobile or non-mobile.

Exampes for non-mobile devices are datacentres, telecommunications and storage systems.

Exampes for mobile devices are personal computers, microprocessors, cell phones, and personal digital assistants or devices which are located in e.g. vehicles, such as automobiles, planes or ships.

In a preferred embodiment electronic devices may be cooled according to the invention to which a voltage is applied of not more than 60 V, preferably not more than 50 V, more preferably not more than 40 V, and even more preferably not more than 35 V. The voltage refers to that part of the device in direct contact with the coolant.

In an especially preferred embodiment the voltage applied is not more than 25 V, preferably not more than 20 V, more preferably not more than 15 V, and even more preferably not more than 12 V.

Devices with a higher voltage applied may be cooled according to the present invention, such as power supply units or transformers, however, a higher voltage, such as 110 V or 220 V, increases the scope of electrolysis of the coolant, such as the water in the coolant. Hence, in this case measures to remove ionic products of hydrolysis have to be taken (see below).

The electronic device includes a thermal management system that includes at least one recirculating thermal management fluid. The thermal management system is designed to transfer heat from the heat-generating electronic device to a condenser or heat exchanger. The thermal management system can recirculate the thermal management fluid passively or by using mechanical equipment such as, for example, a pump. Passive recirculating systems work by transferring heat from the electronic device to the thermal management fluid until it typically is vaporized, allowing the heated vapor to proceed to a condenser at which it can transfer its heat to the condenser surface and condense back into a liquid, and then allowing the condensed liquid to reflow into the thermal management fluid in contact with the electronic device.

In a preferred embodiment the system according to the present invention comprises a heat exchanger but not a condenser, since the cooling liquid according to the invention does not evaporate and the cooling system is operated under conditions well below the boiling point of the coolant so that no phase transfer occurs.

Passive thermal management systems can include, for example, single phase or two-phase immersion cooling. In other embodiments, thermal management systems can include pumped two-phase systems. The thermal management system can also include facilities for managing the heat transfer fluid, including, e.g., pumps, valves, fluid containment systems, pressure control systems, condensers, heat exchangers, heat sources, heat sinks (usually outside air, ground water or river water), refrigeration systems, active temperature control systems, temperature and/or pressure sensors, flame sensors, carbon dioxide sensors, and passive temperature control systems.

The provided system includes the nonflammable, inert, aqueous thermal transfer medium according to the invention. By nonflammable it is meant that the medium does not easily support combustion (e.g. do not show a flash point according to ASTM D-3278-96 e-1 "Flash Point of-Liquids by Small Scale Closed-Cup Apparatus"). As aqueous mediums the thermal transfer mediums according to the present invention are nonflammable and with a sufficient water content do not exhibit a flash point. By inert it is meant that under normal operating conditions of the system, the medium does not substantially react with the components of the system or the electronic device.

Sometimes, water-based coolants have the disadvantage that they may contribute to corrosion in the metallic constituents of the coolant circuit and of the system described above. In addition, a cooling medium which has a certain electrical conductivity represents a safety problem. Furthermore, degradation of the constituents of the coolant may lead to compounds increasing the electrical conductivity, e.g. acids as oxidation products of glycols.

Since the electrical conductivity of an aqueous cooling medium likewise drops with decreasing ion concentration, it has already been proposed to use deionized cooling media for fuel cells. For example, US 5,200,278 and WO 00/17951 disclose arranging ion exchangers in the cooling circuit in order that the aqueous coolant remains substantially free from ionic impurities for a certain period. However, a disadvantage of the known systems is that the ion exchanger becomes exhausted after a certain operating time and has to be replaced.

In a preferred embodiment it is proposed in accordance with the present invention that the cooling medium circulating in the cooling circuit be subjected to at least intermittent electrochemical deionization. With the process according to the invention, the cooling circuit in the system operates with virtually no maintenance. As soon as, for example, a conductivity sensor records an increase in the conductivity of the cooling medium, which corresponds to an increase in the ion concentration, voltage can be applied to the electrodes of an electrochemical cell arranged in the cooling circuit, which removes some of the ions from the cooling circuit. Use is preferably made of electrodialysis cells, which can be operated with or without ion exchangers. If ion exchangers are used, the corresponding cells are also known as electrode ionization cells. In cells of this type, the deionization of the medium and the regeneration of the ion exchangers take place at the same time.

One or more heat exchangers are arranged in the cooling circuit. According to a variant of the invention, a first cooling circuit is at the same time the only cooling circuit, and the heat exchanger or exchangers is (are) in contact, for example, with a heat sink, e.g. air or water or another suitable cooling medium. However, the first cooling circuit may also, as primary circuit, be in thermal contact with a second circuit (secondary circuit).

According to a preferred embodiment of the process according to the invention, the deionization of the cooling medium is carried out continuously during operation of the system.

Since lower residual conductivities of the cooling medium can be achieved on use of ion exchangers than in the case of pure electrodialysis, use is preferably made of electrode ionization cells, and the cooling medium is passed through the cell as diluate stream.

Electrode ionization cells are known per se and are used, for example, for the desalination of sea water. An electrode ionization cell of this type may consist, for example, of a mixed bed of anion and cation exchanger resins. According to another variant, anion and cation exchanger resins are arranged in two separate chambers.

The diluate stream is advantageously cooled before the deionization in order to keep the temperature of the solutions in contact with the ion exchanger components low. To this end, the electrode ionization cell may, for example, be arranged downstream (based on the flow directions of the diluate) of the coolers or heat exchangers in the first cooling circuit.

According to a particularly preferred variant, the first cooling circuit is designed as primary cooling circuit, with the depleted diluate stream coming into contact with the corrosion-endangered components. The concentrate stream from the electrode ionization cell can then be allowed to circulate in a second cooling circuit, the secondary cooling circuit, and cooled in a primary heat exchanger. The cooled concentrate stream can subsequently be used for cooling the diluate stream. The secondary circuit of the concentrate stream can have a water supply with which the water losses occurring in operation during regeneration of the ion exchangers can be compensated. In this variant, the heat from the diluate stream, after leaving the heat generating device, is preferably transferred to the secondary circuit containing the concentrate stream via a primary cooler. The cooled diluate stream subsequently passes through the electrode ionization cell. The heated concentrate stream is passed through the primary cooler and subsequently into the electrode ionization cell, where it takes up the ions migrating out of the diluate.

The present invention also relates to a system having at least one heat generating device and a first cooling circuit for the heat generating device, wherein at least one electrode ionization cell, through which a diluate stream serving as cooling medium and a concentrate stream flow, is arranged in the cooling circuit. It is possible to use a very wide variety of electrode ionization cells known per se (cf., for example, Ganzi et al. "Electrodeionization", Ultrapure Water, July/- August 1997).

The electrodes of the electrode ionization cells can be made of suitable materials, for example noble metals, in particular platinum, metal oxides or graphite. The cathodes may also consist, for example, of steel or nickel. The separation between the membranes is usually from several hundred µm to a few cm. The current densities are dependent on the residual conductivities of the solutions and can be from a few mA/m2 to several A/m2. In the case of continuous operation, the energy requirement of an electrode ionization cell of this type is less than one watt per liter of solution.

According to a variant of the invention, the chambers of the electrode ionization cell do not contain ion exchanger packing. In this case, the cell is operated as a pure electrodialysis cell. However, the achievable residual conductivities are greater than in the case of a comparable electrode ionization cell containing ion exchanger packing.

However, ion exchanger packing is particularly preferably provided. The ion exchanger may consist, for example, of a mixed bed of anion and cation exchanger resins which is delimited on the cathode side by a cation exchanger membrane and on the anode side by an anion exchanger membrane. The diluate stream to be depleted flows through the packing. The ion exchanger membranes are in contact on the side opposite the ion exchanger bed with the concentrate stream, which is at the same time in contact with the electrodes, between which the electric field is built up. This variant offers the possibility of constructing a number of diluate and concentrate chambers alternately in order to facilitate greater volume throughput for the same electrode surface area.

According to another variant, the diluate flows through the cation exchanger resin and anion exchanger resin in two separate chambers. The cation exchanger resin packing here is delimited on the one hand from the concentrate stream by a cation exchanger membrane and on the other hand from the anion exchanger resin packing by a so-called bipolar membrane. At the bipolar membrane, protons are liberated on the side of the cation exchanger resin packing and hydroxyl ions on the side of the anion exchanger resin packing. The anion exchanger resin packing is itself delimited from the concentrate stream by an anion exchanger membrane.

### Examples

The invention is illustrated in the following examples, but without it being restricted thereto.

Coolant compositions were prepared by mixing the constituents as listed in Table 1 (all amounts given in weight%) and the features and physical parameters as pointed out in Table 1 were determined as follows:

| Appearance | Visual |
|---|---|
| Water, % | DIN 51777 |
| Density at 20 °C, g/cm3 | DIN 51757 |
| pH as-is | ASTM D 1287 |
| Reserve alkalinity of 10 mL, mL 0.1 mol/L HCl | ASTM D 1121 |
| Refractive index at 20 °C | DIN 51423 |
| Conductivity at 25 °C, µS/cm | ASTM D 1125 |

Examples 2, 4, 5, and 6 are for comparative purposes, Examples 1, 3, 7, and 8 are according to the invention.

The coolants were brought to a slightly alkaline pH-value using different bases in order to ensure a sufficient reserve alkalinity which is necessary to buffer acidic degradation products of the coolant.

It can easily be seen that the use of the strong bases potassium and sodium hydroxide (Comparative Examples 4 and 5) in order to achieve the target pH-value due to their full dissociation raise the electrical conductivity to an unacceptable high value.

Using di isopropyl amine as base (Comparative Example 2) lowers the electrical conductivity, however, it still remains above the critical value of 50 µS/cm. This critical value is achieved only the bases (E) according to the invention (octyl diethanol amine in Example 3 and preferably triethanolamine in Example 1).

Variation of the carboxylic acids shows that use of the dicarboxylic acid sebacic acid (Comparative Example 6) leaves the electrical conductivity above the critical value of 50 µS/cm. The aromatic monocarboxylic acid benzoic acid (Example 8) yields good values with the aliphatic monocarboxylic acids ethylhexanoic acid (Example 7) and especially isononanoic acid (Example 1) being most preferred.

**Table 1**

| **Raw material** | **Ex 1** | **Ex 2 (Comp)** | **Ex 3** | **Ex 4 (Comp)** | **Ex 5 (Comp)** | **Ex 6 (Comp)** | **Ex 7** | **Ex 8** |
|---|---|---|---|---|---|---|---|---|
| Monoethylene glycol | 49.89 | 49.92 | 49.86 | 49.91 | 49.93 | 49.88 | 49.89 | 49.89 |
| Pure water (distilled) | 49.81 | 49.81 | 49.81 | 49.81 | 49.81 | 49.81 | 49.81 | 49.81 |
| Tolutriazole | 0.1 | 0.1 | 0.1 | 0.1 | 0.1 | 0.1 | 0.1 | 0.1 |
| Tetraethoxysilane | 0.1 | 0.1 | 0.1 | 0.1 | 0.1 | 0.1 | 0.1 | 0.1 |
| Triethanol amine (85%) | 0.08 | | | | | 0.08 | 0.08 | 0.08 |
| Isononanoic acid | 0.02 | 0.02 | 0.02 | 0.02 | 0.02 | | | |
| Di isopropyl amine | | 0.05 | | | | | | |
| Octyl diethanol amine | | | 0.11 | | | | | |
| Potassium hydroxide (KOH), 48% | | | | 0.06 | | | | |
| Sodium hydroxide (NaOH), 50% | | | | | 0.04 | | | |
| Sebacic acid | | | | | | 0.03 | | |
| Ethylhexanoic acid | | | | | | | 0.02 | |
| Benzoic acid | | | | | | | | 0.02 |
| Total | 100 | 100 | 100 | 100 | 100 | 100 | 100 | 100 |

| Appearance | clear, colorless | clear, colorless | clear, colorless | clear, colorless | clear, colorless | clear, colorless | clear, colorless | clear, colorless |
|---|---|---|---|---|---|---|---|---|
| Water, % | 50.3 | 50.5 | 50.3 | 49.8 | 48.5 | 50.7 | 50.1 | 50.1 |
| Density at 20 °C, g/cm3 | 1.065 | 1.065 | 1.065 | 1.065 | 1.065 | 1.065 | 1.065 | 1.065 |
| pH as-is | 7.7 | 8.2 | 8.2 | 8.6 | 8.6 | 7.3 | 7.7 | 7.8 |
| Reserve alkalinity of 10 mL, mL 0.1 mol/L HCl | 0.4 | 0.4 | 0.5 | 0.5 | 0.4 | 0.3 | 0.5 | 0.4 |
| Refractive index at 20 °C | 1.384 | 1.384 | 1.384 | 1.383 | 1.384 | 1.384 | 1.384 | 1.384 |
| Electr. Conductivity, µS/cm | 40 | 54 | 50 | 166 | 135 | 73 | 41 | 43 |

### Corrosion Examples

The coolant compositions of Example 1 and the composition of Example 1 further comprising 0.01 wt% of a silicophosphonate (Formula (V), R⁵ = 1,3-propylene, R⁶, R⁷ = methyl and ethyl (statistical mixture), sodium salt) were compared in corrosion tests according to ASTM D 1384 at 88 °C.

Values for pH, reserve alkalinity, electrical conductivity, and silicon content were determined before and after the corrosion test.

| Sample | Ex. 1 | **Ex.1** + 0.01% silicophosphonate (38% in water) |
|---|---|---|
| Weight change, mg/cm² | | |
| Copper | 0.06 | 0.04 |
| Steel H - II | 0.02 | 0.02 |
| Steel 1.4301 | 0.05 | 0.07 |
| Cast aluminum G-ALSi6Cu4 | 0 | -0.01 |
| pH before test | 7.82 | 7.74 |
| pH after test | 7.64 | 7.71 |
| pH change, % | -2% | 0% |
| RA before test (mL 0.1 mol/L HCl) | 0.45 | 0.46 |
| RA before test (mL 0.1 mol/L HCl) | 0.38 | 0.41 |
| RA change, % | -16% | -11% |
| Conductivity before test (µS/cm) | 39.2 | 41.2 |
| Conductivity after test (µS/cm) | 51.5 | 51.5 |
| Conductivity change, % | 31% | 25% |
| Si calculated before test (ppm) | 135 | 140 |
| Si after test (ppm) | 42 | 70 |
| Si change (%) | -69% | -50% |

While the results of the corrosion test and pH-value are comparable within the accuracy of measurement, the drop of reserve alkalinity and loss of silicon content is less distinctive in the presence of the silicophosphonate than in its absence.

It is, therefore, preferred that the coolants contain at least one silicophosphonate which reduces the consumption of tetraethoxysilane which acts as an inhibitor of aluminium corrosion.

### Application Examples

### Application Example 1 (Comparative)

A commercially available coolant comprising mono ethylene glycol, water, sebacic acid, adipic acid, sodium metasilicate, silicophosphonate, and tolutriazole and exhibiting an electrical conductivity of 4100 µS/cm was used.

A Raspberry Pi 4 computer including USB-C power supply, Micro HDMI ports, USB 2 port, USB 3 port, Gigabit Ethernet port and 4 GB RAM was connected to a power source through the USB-C port and a LCD flat screen through a Micro HDMI port. A program on the Raspberry Pi 4 was initiated delivering a short film loop to the connected flat screen. Next, the Raspberry Pi 4 computer was slowly submerged in a tank filled with the coolant described above until the entire unit was immersed. The immersion was maintained for 5 minutes. During this time, the computer continued normal operation. The short film loop was displayed on the connected flat screen all the time with no signs of malfunction or interference. Formation of deposit on the computer and continued gas evolution were observed. The control LED of the computer was active. After the immersion period, the computer was removed from the fluid tank in order not to provoke a short circuit, access fluid was removed by pressurized air and the computer was left to dry under ambient conditions. During this time and for the following 10 minutes of the experiment, the short film loop was displayed on the connected flat screen with no signs of malfunction or interference. Visual inspection of the computer revealed deposit formation in various parts of the computer, mainly on the connector pins.

### Application Example 2

A commercially available coolant comprising mono ethylene glycol, water, tetraethoxysilane, and benzotriazole and exhibiting an electrical conductivity of 1.2 µS/cm was used.

Application Example 1 was repeated using a coolant according to the invention. During the immersion time (5 minutes) and thereafter (10 minutes) the computer continued normal operation with no signs of malfunction or interference.

No deposit formation on the computer was observed, nor was any gas evolution visible. Visual inspection of the computer revealed no changes. Connector pins remained in clean, pristine state.

## Claims

1. Use of a coolant, comprising
(A) at least one glycol
(B) water
(C) at least one azole derivative
(D) at least one ester of orthosilicic acid or alkoxy alkylsilane
(E) optionally at least one tertiary amine bearing at least one 2-hydroxyethyl- or 2-hydroxypropyl-group
(F) optionally at least one monocarboxylic acid
(G) optionally at least one silicophosphonate
(H) optionally at least one further coolant additive
wherein
- components (C) to (H) are present in amounts so that the coolant exhibits an electrical conductivity of less than 50, preferably less than 45 µS/cm
for thermally managing heat-generating electronic devices, preferably electronic devices comprising a datacentre, more preferably electronic devices comprising a datacentre comprising an electronic component.

2. Method of thermally managing heat-generating electronic devices, preferably electronic devices comprising a datacentre, more preferably electronic devices comprising a datacentre comprising an electronic component by directly or indirectly bringing the heat-generating electronic devices in contact with a coolant as described in claim 1, conveying the coolant to a heat exchanger and recirculating the coolant.

3. Use and method according to Claim 1 or 2, wherein the glycol (A) is selected from the group consisting of monoethylene glycol, diethylene glycol, triethylene glycol, tetraethylene glycol, monopropylene glycol, dipropylene glycol, 1,3-propanediol, higher poly alkylene glycols, alkylene glycol ethers, and glycerol.

4. Use and method according to any of the preceding claims, wherein the azole derivative (C) is selected from the group consisting of benzimidazole, benzotriazole, tolutriazole, hydrogenated tolutriazole, (2-benzothiazylthio)acetic acid, and (2-benzothiazylthio) propionic acid.

5. Use and method according to any of the preceding claims, wherein the ester of orthosilicic acid (D) is orthosilicic acid tetra ethyl ester or orthosilicic acid tetra methyl ester.

6. Use and method according to any of the preceding claims, wherein the tertiary amine (E) is selected from compounds
- of the general formula (I) 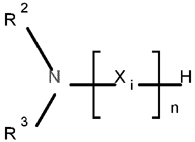 where
R² and R³ independently of another each are a substituent as described above, preferably a linear or branched, preferred a linear alkyl substituent comprising 1 to 18 carbon atoms, preferably 2 to 16, more preferably 4 to 14, and especially 6 to 12 carbon atoms, or together may form a five- or six-membered ring including the nitrogen atom,
Xᵢ is -CH₂-CH₂-O-, -CH₂-CH(CH₃)-O- or -CH(CH₃)-CH₂-O-, preferably -CH₂-CH₂-O-, and n is a positive integer from 1 to 5, preferably from 1 to 4, more preferably from 1 to 3, even more preferably 1 or 2, and especially 1,
- of the general formula (II) 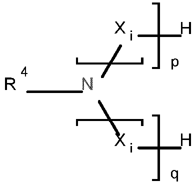 where
R⁴ is a substituent as described above, preferably a linear or branched, preferred a linear alkyl substituent comprising 1 to 18 carbon atoms, preferably 2 to 16, more preferably 4 to 14, and especially 6 to 12 carbon atoms,
each Xi for i = 1 to p and 1 to q is independently selected from the group consisting of -CH₂-CH₂-O-, -CH₂-CH(CH₃)-O- or -CH(CH₃)-CH₂-O-, preferably -CH₂-CH₂-O-, and
p and q independently of another are a positive integer from 1 to 5, preferably from 1 to 4, more preferably from 1 to 3, even more preferably 1 or 2, and especially 1, and
- tertiary amines bearing three 2-hydroxyethyl- or 2-hydroxypropyl-groups.

7. Use and method according to Claim 6, wherein the tertiary amine of general formula (I) is selected from the group consisting of dimethyl ethanolamine, dimethyl propanolamine, diethyl ethanolamine, diethyl propanolamine, di-n-butyl ethanolamine, di-n-butyl propanolamine, N-hydroxyethyl pyrrolidine, N-hydroxyethyl piperidine, and N-hydroxyethyl morpholine.

8. Use and method according to Claim 6, wherein the tertiary amine of general formula (I) are bis(2-hydroxyethyl) amines or bis(2-hydroxypropyl) amines bearing as substituent R⁴ n-hexylamine, 2-methylpentylamine, n-heptylamine, 2-heptylamine, isoheptylamine, 1-methylhexylamine, n-octylamine, 2-ethylhexylamine, 2-aminooctane, 6-methyl-2-heptylamine, n-nonylamine, isononylamine, n-decylamine and 2-propylheptylamine or mixtures thereof.

9. Use and method according to Claim 6, wherein the tertiary amine bearing three 2-hydroxyethyl- or 2-hydroxypropyl-groups is selected from the group consisting of triethanolamine and tripropanolamine.

10. Use and method according to any of the preceding claims, wherein the monocarboxylic acid (F) is aliphatic, aromatic or cycloaliphatic, preferably aliphatic with 5 to 14 carbon atoms, preferably from 6 to 12 carbon atoms.

11. Use and method according to any of the preceding claims, wherein the monocarboxylic acid (F) is linear or branched, preferably branched aliphatic.

12. Use and method according to any of the preceding claims, wherein the monocarboxylic acid (F) is selected from the group consisting of 2-ethylhexanoic acid and isononanoic acid.

13. Use and method according to any of the preceding claims, wherein no carboxylic acids with a functionality of more than 1 are present.

14. Use and method according to any of the preceding claims, wherein both tertiary amine (E) and monocarboxylic acid (F) are present and the molar ratio between tertiary amine (E) and monocarboxylic acid (F) is from 1 : 0.1 to 1 : 0.6.

15. Use and method according to any of the claims 1 to 5, wherein no tertiary amine (E) and no monocarboxylic acid (F) is present.

16. System, comprising at least one heat-generating electronic device in direct or indirect contact with a coolant as described in any of the preceding claims, in which the coolant is recirculated in a thermal management system to at least one condenser or heat exchanger, preferably a heat exchanger in contact with a heat sink, and recirculated to the at least one heat-generating electronic device.

17. System according to claim 16, wherein the at least one heat-generating electronic device is selected from the group consisting of microprocessors, wafers used to manufacture semiconductor devices, power control semiconductors, circuit boards, multi-chip modules, packaged or unpackaged semiconductor devices, semiconductor integrated circuits, personal computers, microprocessors, servers, cell phones, personal digital assistants, and datacentres.

18. System according to claim 16 or 17, wherein the applied voltage does not exceed 60 V.

## Patentansprüche

1. Verwendung eines Kühlmittels, umfassend
(A) zumindest ein Glykol
(B) Wasser
(C) zumindest ein Azolderivat.
(D) zumindest einen Ester der Orthokieselsäure oder Alkoxyalkylsilan
(E) optional zumindest ein tertiäres Amin, das mindestens eine 2-Hydroxyethyl- oder 2-Hydroxypropylgruppe trägt
(F) optional zumindest eine Monocarbonsäure
(G) optional zumindest ein Siliciumphosphonat
(H) optional zumindest ein weiteres Kühlmitteladditiv
wobei
- die Komponenten (C) bis (H) in solchen Mengen enthalten sind, dass das Kühlmittel eine elektrische Leitfähigkeit von weniger als 50, vorzugsweise weniger als 45 µS/cm zeigt
zum thermischen Verwalten von wärmeerzeugenden elektronischen Vorrichtungen, vorzugsweise elektronischen Vorrichtungen, die ein Rechenzentrum umfassen, besonders bevorzugt elektronischen Vorrichtungen, die ein Rechenzentrum umfassen, das eine elektronische Komponente umfasst.

2. Verfahren zum thermischen Verwalten von wärmeerzeugenden elektronischen Vorrichtungen, vorzugsweise elektronischen Vorrichtungen, die ein Rechenzentrum umfassen, besonders bevorzugt elektronischen Vorrichtungen, die ein Rechenzentrum umfassen, das eine elektronische Komponente umfasst, indem die wärmeerzeugenden elektronischen Vorrichtungen direkt oder indirekt mit einem Kühlmittel in Kontakt gebracht werden, wie in Anspruch 1 beschrieben, wobei das Kühlmittel zu einem Wärmetauscher gefördert und das Kühlmittel zurückgeführt wird.

3. Verwendung und Verfahren nach Anspruch 1 oder 2, wobei das Glykol (A) aus der Gruppe ausgewählt wird, die besteht aus Monoethylenglykol, Diethylenglykol, Triethylenglykol, Tetraethylenglykol, Monopropylenglykol, Dipropylenglykol, 1,3-Propandiol, höheren Polyalkylenglykolen, Alkylenglykolethern und Glycerin.

4. Verwendung und Verfahren nach einem der vorstehenden Ansprüche, wobei das Azolderivat (C) aus der Gruppe ausgewählt wird, die besteht aus Benzimidazol, Benzotriazol, Tolyltriazol, hydrogeniertem Tolyltriazol, (2-Benzothiazylthio-)Essigsäure und (2-Benzothiazylthio- )Propionsäure.

5. Verwendung und Verfahren nach einem der vorhergehenden Ansprüche, wobei der Ester der Orthokieselsäure (D) Orthokieselsäuretetraethylester oder Orthokieselsäuretetramethylester ist.

6. Verwendung und Verfahren nach einem der vorhergehenden Ansprüche, wobei das tertiäre Amin (E) ausgewählt wird aus Verbindungen
- der allgemeinen Formel (I) 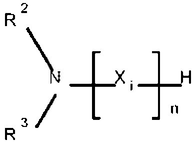 wobei
R² und R³ unabhängig voneinander jeweils für einen Substituenten wie oben beschrieben stehen, vorzugsweise für einen linearen oder verzweigten, bevorzugt einen linearen Alkylsubstituenten mit 1 bis 18 Kohlenstoffatomen, vorzugsweise 2 bis 16, besonders bevorzugt 4 bis 14 und insbesondere 6 bis 12 Kohlenstoffatomen, oder zusammen einen fünf- oder sechsgliedrigen Ring einschließlich des Stickstoffatoms bilden können,
Xᵢ für -CH₂-CH₂-O-, -CH₂-CH(CH₃)-O- oder -CH(CH₃)-CH₂-O-, bevorzugt -CH₂-CH₂-O-, steht und n eine positive ganze Zahl von 1 bis 5 ist, bevorzugt von 1 bis 4, weiter bevorzugt von 1 bis 3, noch weiter bevorzugt 1 oder 2 und insbesondere 1,
- der allgemeinen Formel (II) 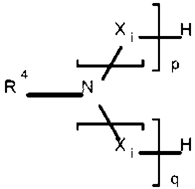 wobei
R⁴ ein Substituent wie oben beschrieben ist, vorzugsweise ein linearer oder verzweigter, bevorzugt linearer Alkylsubstituent, der 1 bis 18 Kohlenstoffatome, vorzugsweise 2 bis 16, besonders bevorzugt 4 bis 14 und insbesondere 6 bis 12 Kohlenstoffatome umfasst,
jedes Xi für i = 1 bis p und 1 bis q unabhängig aus der Gruppe ausgewählt wird, die besteht aus -CH₂-CH₂-O-, - CH₂-CH(CH₃)-O- oder -CH(CH₃)-CH₂-O-, bevorzugt -CH₂-CH₂-O-, und p und q unabhängig voneinander jeweils eine positive ganze Zahl von 1 bis 5 sind, bevorzugt von 1 bis 4, besonders bevorzugt von 1 bis 3, noch weiter bevorzugt 1 oder 2 und insbesondere 1, und
- tertiäre Amine drei 2-Hydroxyethyl- oder 2-Hydroxypropylgruppen tragen.

7. Verwendung und Verfahren nach Anspruch 6, wobei das tertiäre Amin der allgemeinen Formel (I) aus der Gruppe ausgewählt wird, die besteht aus Dimethylethanolamin, Dimethylpropanolamin, Diethylethanolamin, Diethylpropanolamin, Di-n-butylethanolamin, Di-n-butylpropanolamin, N-Hydroxyethylpyrrolidin, N-Hydroxyethylpiperidin und N-Hydroxyethylmorpholin.

8. Verwendung und Verfahren nach Anspruch 6, wobei das tertiäre Amin der allgemeinen Formel (I) Bis(2-hydroxyethyl)amine oder Bis(2-hydroxypropyl)amine sind, die als Substituenten R⁴ n-Hexylamin, 2-Methylpentylamin, n-Heptylamin, 2-Heptylamin, Isoheptylamin, 1-Methylhexylamin, n-Octylamin, 2-Ethylhexylamin, 2-Aminooctan, 6-Methyl-2-heptylamin, n-Nonylamin, Isononylamin, n-Decylamin und 2-Propylheptylamin oder Mischungen davon tragen.

9. Verwendung und Verfahren nach Anspruch 6, wobei das tertiäre Amin, das drei 2-Hydroxyethyl- oder 2-Hydroxypropyl-Gruppen trägt, ausgewählt wird aus der Gruppe, die besteht aus Triethanolamin und Tripropanolamin.

10. Verwendung und Verfahren nach einem der vorhergehenden Ansprüche, wobei die Monocarbonsäure (F) aliphatisch, aromatisch oder cycloaliphatisch, vorzugsweise aliphatisch mit 5 bis 14 Kohlenstoffatomen, vorzugsweise 6 bis 12 Kohlenstoffatomen ist.

11. Verwendung und Verfahren nach einem der vorstehenden Ansprüche, wobei die Monocarbonsäure (F) linear oder verzweigt ist, vorzugsweise verzweigt aliphatisch.

12. Verwendung und Verfahren nach einem der vorstehenden Ansprüche, wobei die Monocarbonsäure (F) aus der Gruppe ausgewählt wird, die besteht aus 2-Ethylhexansäure und Isononansäure.

13. Verwendung und Verfahren nach einem der vorhergehenden Ansprüche, wobei keine Carbonsäuren mit einer Funktionalität von mehr als 1 vorhanden sind.

14. Verwendung und Verfahren nach einem der vorhergehenden Ansprüche, wobei sowohl tertiäres Amin (E) als auch Monocarbonsäure (F) vorhanden sind und das Molverhältnis zwischen tertiärem Amin (E) und Monocarbonsäure (F) von 1 : 0,1 bis 1 : 0,6 reicht.

15. Verwendung und Verfahren nach einem der Ansprüche 1 bis 5, wobei kein tertiäres Amin (E) und keine Monocarbonsäure (F) vorhanden ist.

16. System, umfassend mindestens eine wärmeerzeugende elektronische Vorrichtung in direktem oder indirektem Kontakt mit einem Kühlmittel, wie in einem der vorhergehenden Ansprüche beschrieben, wobei das Kühlmittel in einem Wärmeverwaltungssystem zu mindestens einem Kondensator oder Wärmetauscher, vorzugsweise einem Wärmetauscher in Kontakt mit einer Wärmesenke, zurückgeführt wird und zu der mindestens einen wärmeerzeugenden elektronischen Vorrichtung zurückgeführt wird.

17. System nach Anspruch 16, wobei die mindestens eine wärmeerzeugende elektronische Vorrichtung aus der Gruppe ausgewählt wird, die besteht aus Mikroprozessoren, Wafern, die zum Herstellen von Halbleitervorrichtungen verwendet werden, Leistungssteuerungshalbleitern, Leiterplatten, Mehrchipmodulen, verpackten oder unverpackten Halbleitervorrichtungen, integrierten Halbleiterschaltungen, Personalcomputern, Mikroprozessoren, Servern, Mobiltelefonen, persönlichen digitalen Assistenten und Rechenzentren.

18. System nach Anspruch 16 oder 17, wobei die angelegte Spannung 60 V nicht überschreitet.

## Revendications

1. Utilisation d'un fluide réfrigérant, comprenant
(A) au moins un glycol
(B) de l'eau
(C) au moins un dérivé d'azole
(D) au moins un ester d'acide orthosilicique ou alcoxy alkylsilane
(E) éventuellement au moins une amine tertiaire porteuse d'au moins un groupement 2-hydroxyéthyl- ou 2-hydroxypropyl-
(F) éventuellement au moins un acide monocarboxylique
(G) éventuellement au moins un silicophosphonate
(H) éventuellement au moins un autre additif pour fluide réfrigérant
dans lequel
- les composants (C) à (H) sont présents en des quantités de sorte que le fluide réfrigérant présente une conductivité électrique inférieure à 50, de préférence inférieure à 45 µS/cm
pour la gestion thermique de dispositifs électroniques dégageant de la chaleur, de préférence de dispositifs électroniques comprenant un centre de données, plus préférablement de dispositifs électroniques comprenant un centre de données comprenant un composant électronique.

2. Procédé de gestion thermique de dispositifs électroniques dégageant de la chaleur, de préférence de dispositifs électroniques comprenant un centre de données, plus préférablement de dispositifs électroniques comprenant un centre de données comprenant un composant électronique en mettant directement ou indirectement en contact les dispositifs électroniques dégageant de la chaleur avec un fluide réfrigérant tel que décrit dans la revendication 1, transportant le fluide réfrigérant vers un échangeur de chaleur et remettant en circulation le fluide réfrigérant.

3. Utilisation et procédé selon la revendication 1 ou 2, dans lesquels le glycol (A) est choisi dans le groupe constitué par monoéthylèneglycol, diéthylèneglycol, triéthylèneglycol, tétra-éthylèneglycol, monopropylèneglycol, dipropylèneglycol, 1,3-propanediol, polyalkylène glycols supérieurs, éthers d'alkylène glycol et glycérol.

4. Utilisation et procédé selon l'une quelconque des revendications précédentes, dans lesquels le dérivé d'azole (C) est choisi dans le groupe constitué par benzimidazole, benzotriazole, tolutriazole, tolutriazole hydrogéné, acide (2-benzothiazylthio)acétique et acide (2-benzothiazylthio)propionique.

5. Utilisation et procédé selon l'une quelconque des revendications précédentes, dans lesquels l'ester d'acide orthosilicique (D) est l'ester tétraéthyle de l'acide orthosilicique ou l'ester tétraméthyle de l'acide orthosilicique.

6. Utilisation et procédé selon l'une quelconque des revendications précédentes, dans lesquels l'amine tertiaire (E) est choisie parmi les composés
- de la formule générale (I) 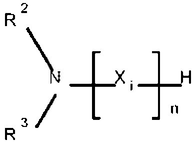 où
R² et R³, indépendamment l'un de l'autre, sont chacun un substituant tel que décrit ci-dessus, de préférence un substituant alkyle linéaire ou ramifié, de préférence linéaire, comprenant 1 à 18 atomes de carbone, de préférence 2 à 16, plus préférablement 4 à 14, et notamment 6 à 12 atomes de carbone, ou ensemble peuvent former un cycle à cinq ou six chaînons incluant l'atome d'azote,
Xᵢ est -CH₂-CH₂-O-, -CH₂-CH(CH₃)-O- ou -CH(CH₃)-CH₂-O-, de préférence -CH₂-CH₂-O-, et n est un nombre entier positif de 1 à 5, de préférence de 1 à 4, plus préférablement de 1 à 3, encore plus préférablement 1 ou 2, et notamment 1,
- de la formule générale (II) 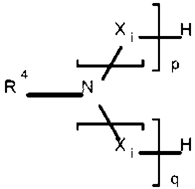 où
R⁴ est un substituant tel que décrit ci-dessus, de préférence un substituant alkyle linéaire ou ramifié, de préférence linéaire, comprenant 1 à 18 atomes de carbone, de préférence 2 à 16, plus préférablement 4 à 14, et notamment 6 à 12 atomes de carbone,
chaque Xi pour i = 1 à p et 1 à q est indépendamment choisi dans le groupe constitué par -CH₂-CH₂-O-, -CH₂-CH(CH₃)-O- ou-CH(CH₃)-CH₂-O-, de préférence -CH₂-CH₂-O-, et p et q indépendamment l'un de l'autre sont un entier positif de 1 à 5, préférablement de 1 à 4, plus préférablement de 1 à 3, encore plus préférablement 1 ou 2, et notamment 1, et
- des amines tertiaires portant trois groupes 2-hydroxyéthyl- ou 2-hydroxypropyl-.

7. Utilisation et procédé selon la revendication 6, dans lesquels l'amine tertiaire de formule générale (I) est choisie dans le groupe constitué par diméthyléthanolamine, diméthylpropanolamine, diéthyléthanolamine, diéthylpropanolamine, di-n-butyléthanolamine, di-n-butylpropanolamine, N-hydroxyéthylpyrrolidine, N-hydroxyéthylpipéridine, N-hydroxyéthylmorpholine.

8. Utilisation et procédé selon la revendication 6, dans lesquels l'amine tertiaire de formule générale (I) est des bis(2-hydroxyéthyl)amines ou des bis(2-hydroxypropyl)amines portant, en tant que substituant R⁴, n-hexylamine, 2-méthylpentylamine, n-heptylamine, 2-heptylamine, isoheptylamine, 1-méthylhexylamine, n-octylamine, la 2-éthylhexylamine, 2-aminooctane, 6-méthyl-2-heptylamine, n-nonylamine, isononylamine, n-décylamine, et 2-propylheptylamine ou des mélanges de ceux-ci.

9. Utilisation et procédé selon la revendication 6, dans lesquels l'amine tertiaire portant trois groupes 2-hydroxyéthyl- ou 2-hydroxypropyl- est choisie dans le groupe constitué par triéthanolamine et tripropanolamine.

10. Utilisation et procédé selon l'une quelconque des revendications précédentes, dans lesquels l'acide monocarboxylique (F) est aliphatique, aromatique ou cycloaliphatique, de préférence aliphatique avec 5 à 14 atomes de carbone, de préférence de 6 à 12 atomes de carbone.

11. Utilisation et procédé selon l'une quelconque des revendications précédentes, dans lesquels l'acide monocarboxylique (F) est linéaire ou ramifié, de préférence aliphatique ramifié.

12. Utilisation et procédé selon l'une quelconque des revendications précédentes, dans lesquels l'acide monocarboxylique (F) est choisi dans le groupe constitué par acide 2-éthylhexanoïque et acide isononanoïque.

13. Utilisation et procédé selon l'une quelconque des revendications précédentes, dans lesquels aucun acide carboxylique ayant une fonctionnalité supérieure à 1 n'est présent.

14. Utilisation et procédé selon l'une quelconque des revendications précédentes, dans lesquels l'amine tertiaire (E) et l'acide monocarboxylique (F) sont présents et le rapport molaire entre l'amine tertiaire (E) et l'acide monocarboxylique (F) est de 1: 0,1 à 1: 0,6.

15. Utilisation et procédé selon l'une quelconque des revendications 1 à 5, dans lesquels aucune amine tertiaire (E) et aucun acide monocarboxylique (F) ne sont présents.

16. Système, comprenant au moins un dispositif électronique dégageant de la chaleur en contact direct ou indirect avec un fluide réfrigérant tel que décrit dans l'une quelconque des revendications précédentes, dans lequel le fluide réfrigérant est remis en circulation dans un système de gestion thermique vers au moins un condenseur ou échangeur de chaleur, de préférence un échangeur de chaleur en contact avec un dissipateur de chaleur, et remis en circulation vers l'au moins un dispositif électronique dégageant de la chaleur.

17. Système selon la revendication 16, dans lequel l'au moins un dispositif électronique dégageant de la chaleur est choisi dans le groupe constitué par microprocesseurs, plaquettes utilisées pour fabriquer des dispositifs à semi-conducteurs, semi-conducteurs de commande de puissance, cartes de circuits imprimés, modules à puces multiples, dispositifs à semi-conducteurs encapsulés ou non, circuits intégrés à semi-conducteurs, ordinateurs personnels, microprocesseurs, serveurs, téléphones cellulaires, assistants numériques personnels et centres de données.

18. Système selon la revendication 16 ou 17, dans lequel la tension appliquée ne dépasse pas 60 V.
